# EUROPEAN PATENT APPLICATION

(11) **EP 2 079 111 A1**
(43) Date of publication of application: **15.07.2009**
(21) Application number: 08100315.4
(22) Date of filing: 10.01.2008
(51) Int. Cl.: H01L 29/78, H01L 29/10, H01L 29/08, H01L 29/417

(54) **Nanoscale CMOS transister with an intrinsic bulk**

(71) Applicant: Khaje Nasir Toosi University of Technology Seyyed Khandan Brdg., 16314 Teheran (IR)
(72) Inventor: Sheikian, Iraj, 63918-46977, Izeh (IR); Raissi, Farshid, 19397-53314, Teheran (IR)
(74) Representative: P&TS Patents & Technology Surveys SA

(57) **Abstract**

A modification to the doping profile of the source of nanoscale MOSFETs is disclosed. The source region comprises a top and bottom region of opposite dopant types. In one embodiment of the invention, the top region does not cover the bottom region completely. In another embodiment, the top region covers the bottom region, in which case connection is made to both of the regions via a trench made into the source. For gate dimensions less than 50 nm and down to 10nm, the extra doped region affects the source and drain potential barriers such that a well defined on and off regions are obtained for intrinsic bulk material. Both p and n channel transistors can be obtained.

## Description

### Field of the invention

The present invention relates to nanoscale MOSFETs. More particularly, the present invention relates to nano size MOSFET smaller than 80nm and down to 10nm, without the need to dope the channel region.

### Description of related art:

| | | |
|---|---|---|
| Relevant US patents : | | |
| 6,946,407 | 9/2005 | Ouyang, et al. |
| 6,773,990 | 8/2004 | Fastow, et al. |
| 7,163,866 | 1/2007 | Assaderaghi, et al. |
| 6,969,618 | 2/2006 | Mouli |
| 7,091,069 | 8/2006 | Doris, et al. |
| 7,151,303 | 12/2006 | Wang, et al. |
| 6,995,452 | 2/2006 | Cho, et al. |
| 7,109,532 | 9/2006 | Lee, et al. |
| 6,596,554 | 7/2003 | Unnirishnan |

### Further references:

1- H.-S. P. Wong, D. J. Frank, P. M. Solomon, C. H.-J. Wann, and J. J. Welser, "Nanoscale CMOS," Proc. IEEE, vol. 87, no. 4, pp. 537-570, 1999.
2- T. Mizuno, "New channel engineering for sub-100 nm MOS devices considering both carrier velocity overshoot and statistical performance fluctuations," IEEE Trans. Elec. Dev. vol. 47, no. 4, pp. 756-761, 2000.
5- E. Murakami, T. Yoshimura, Y. Goto, S. Kimura, "Gate length scalability of n-MOSFETs down to 30 nm: Comparison between LDD and non-LDD structures," IEEE Trans. Electron Dev. vol. 47, no. 4, pp. 835-840, 2000.
6- D. S. Ang, C. H. Ling, "A reassessment of ac hot-carrier degradation in deep-submicrometer LDD N-MOSFET," IEEE Electron Dev. Lett., vol. 24, no. 9, pp. 598-600, 2003.

Koh et al., "Body-Contacted SOI MOSFET Structure with Fully Bulk CMOS Compatible Layout and Process", IEEE Electron Device Letters, vol. 18, No. 3, Mar. 1997, pp. 102-104.

The semiconductor industry has progressed in continuously decreasing the size of MOSFET transistors, in a process which is referred to as scaling. MOSFETs scaling results in problems due to the short distance between the source and the drain. Such problems, which include Drain Induced Barrier Lowering (DIBL) and punch through result in large leakage current and have hampered the possibility of scaling the gate length of MOSFETs below 80 nm.

Another foreseen problem which occurs when device lengths are scaled down to about 10 nm, is the random nature of dopant distribution, dopant density fluctuations, in the channel region, which can cause undesirable threshold voltage variation across the wafer.

In conventional complementary MOS circuits (CMOS) in which both n and p channel devices are fabricated in close proximity of each other, there is a need to create deep n and p type regions called wells. The parasitic thyristors which are created by these well dopings create latch up problems. To alleviate such problems, extra steps have been introduced in fabrication process. These steps add yet to the cost and also consume wafer space.

The US patent document US 5489792 describes a silicon on insulator (SOI) MOSFET transistor in which the source is doped by two opposite regions; the bottom region is lightly doped with respect to the top region and the channel is doped. The function of the oppositely doped region is to create a contact to the floating body of the SOI structure in order to collect carriers which are created by impact ionization. The collection of impact ionization carriers is only relevant to SOI structures for which a floating body might exist; it yet loses any meaning for MOSFET using bulk substrates.

There is hence a need for transistor devices overcoming the above mentioned limitations of the prior art.

### Brief summary of the invention

The invention discloses a new MOSFET transistor aimed at reducing problems with dopant fluctuations, CMOS latch up, and short channel effects, such as DIBL and punch through.

In particular, a goal of the present invention is to propose a new MOSFET fabricated on intrinsic bulk material, so that the dopant fluctuation is eliminated, n and p devices are fabricated without the need to introduce "well" regions, and the mobility of carriers is increased due to an intrinsic channel region, and the regular thyristor latch up problems in CMOS circuits are eliminated. The very large Ion/loff ratio as well as the on and off state currents for both n and p type devices indicate that short channel effects are greatly suppressed as well.

These aims are achieved by means of an MOSFET with an intrinsic bulk comprising an extra dopant region inside the source of a doping type opposite to that of the source.

The nanoscale MOSFET according to the invention allows to overcome the problems of scalability of the gate length below 50 nm and down to 10nm due to short channel effects and doping profile fluctuations. It further does not need a doped channel region to operate properly. The present invention also provides methods to fabricate the said region inside the source and the drain. They can be fabricated either by epitaxial growth or by placing the two oppositely doped regions side by side along the width of the source.

The subject of this invention has been simulated using PISCESS-IIb program which is suitable for overall device lengths down to about 50 nm. Simulations also show that the short channel effects which are encountered in regular MOSFET devices are greatly reduced, without the need to use retrograde or halo doped regions. As simulations show, when the gate voltage is zero the device does turn off and very low leakage current is obtained.

The above and other advantages and features of the present invention will be more clearly understood from the following detailed description which is provided in connection with the accompanying drawings.

### Brief Description of the Drawings

The invention will be better understood with the aid of the description of an embodiment given by way of example and illustrated by the figures, in which:

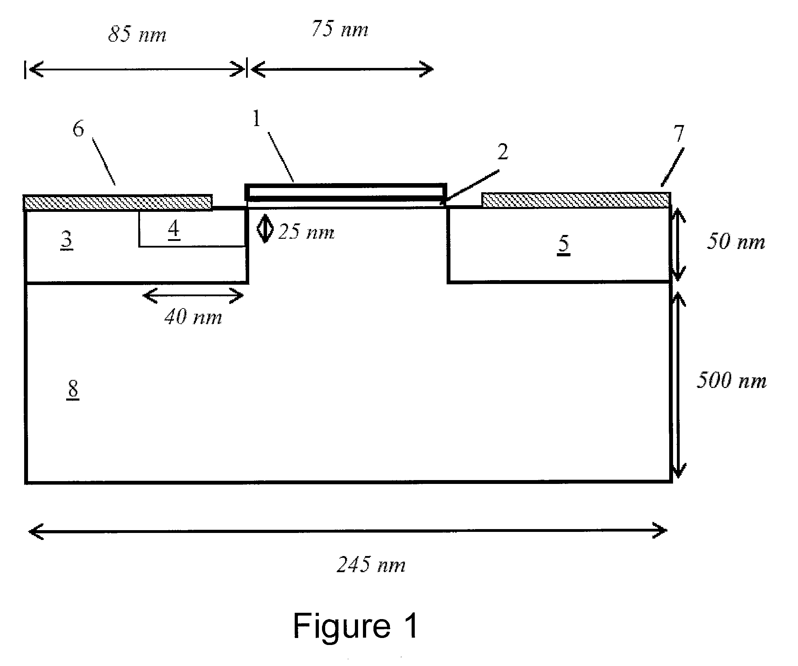

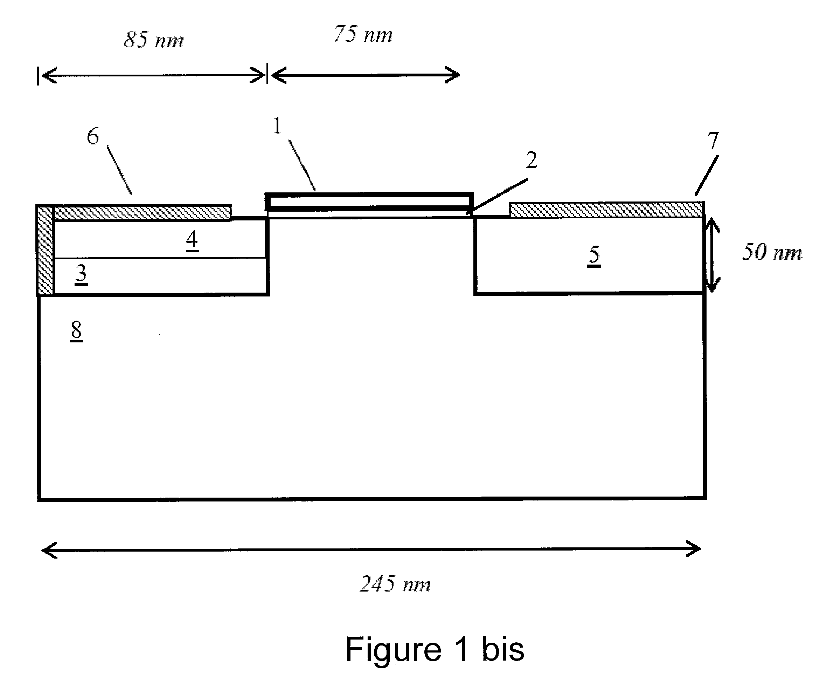

FIG. 1 is a cross-sectional view of the proposed MOSFET according to the invention in a preferred embodiment of the present invention.
FIG. 1 bis gives a side view of another embodiment of the proposed MOSFET according to the invention.
FIG. 2 compares the potential barrier of the present invention with that of a regular MOSFET at a certain voltage applied to the drain with respect to the source.
FIG. 3 demonstrates the relation between the current and voltage between the drain and the source for a regular MOSFET, the bulk is p-type with 10 17/ cm3 impurity concentration, the source and the drain are n-doped at 10 19/cm3.
FIG. 4 demonstrates the relation between the current and voltage between the drain and the source for the subject of this invention, the bulk is intrinsic, drain is n-doped at 10 ¹⁹/cm3 and the two portions of the source are n and p-doped with 10¹⁹/cm3 and 3*10¹⁹/cm3 concentrations.
FIG. 5 demonstrates the simulated OFF current of the regular MOSFET.
FIG. 6 shows the simulated OFF current of the subject of this invention.
FIG. 7 shows the simulated curves of drain-source current according to the drain-source voltage for the subject of this invention with an intrinsic bulk at different gate voltages.

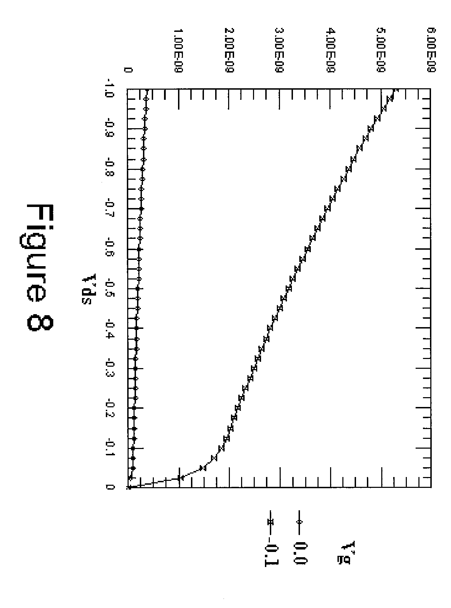

FIG. 8 shows the simulated curves of drain-source current according to the drain-source voltage for proposed MOSFET with zero gate voltage which corresponds to its OFF state. It also shows a simulated curve when the gate voltage is -0.1 volts.

### Detailed Description of possible embodiments of the Invention

In the present invention, the source comprises of two regions of opposite dopant types. The idea of using an intrinsic bulk material in nano dimensions is counter intuitive because in regular MOSFETs the bulk material must be highly doped to reduce short channel effects and yet a MOSFET with an intrinsic bulk does not operate as a transistor and does not turn off. Having a device which has an intrinsic bulk, with well defined on and off states, without suffering from short channel effects must operate based on unforeseen effects. The oppositely doped bottom region of the source creates such effects. It essentially pins the source/ body potential barrier, and this barrier becomes essentially voltage independent, as the voltage of the drain is increased. This is why the problems due to DIBL and punch through are effectively reduced or eliminated. It is thus possible for the gate to decrease or increase this barrier, as a result, the device can be turned on and off.

Those of ordinary skill in the art will appreciate that the following description of the present invention is illustrative only and not in any way limiting.

Referring first to Fig. 1, a cross-sectional view is shown of an illustrative embodiment of the present invention for dimensions most relevant in today's electronic circuitry. The gate 1 is disposed over the oxide layer 2 which is disposed on the active body of the semiconductor 8. The source comprises two regions 3 and 4 of opposite dopings. The region 3 serves two purposes: it makes it possible for the gate voltage to modulate the current from source to the drain by introducing a potential barrier between region 4 and the channel, which can be lowered or increased by the gate; and it also greatly reduces the DIBL problem. DIBL refers to the fact that when the drain is too close to the source such that a voltage applied to it can affect the source side, the potential barrier between the source and body decreases. DIBL causes problems both in the on and off state of the transistor. In the on state, DIBL causes the current to become dependent on the drain voltage which is not desired. In the off state, DIBL causes leakage current as the carriers of the source can go over the lowered potential barrier. Region 3 provides therefore better "ON" characteristics with respect to regular MOSFETs, and it also provides much better lon/loff ratio. Regions 5, 6 and 7 are respectively the drain, and connections to the source and the drain, respectively.

It will be appreciated that the extra dopant region 3 cannot, and should not, be considered as a halo region or lightly doped region as in LDD (lightly doped drain) transistors, since it is not only doped, but preferably highly doped on the source side, with the opposite doping type. Furthermore, this extra dopant region is electrically connected to the source itself. The DIBL lowering and punch-through limitation derived from this feature would not be possible otherwise.

According to figure 1, the source region comprises a lower portion 3 of a first doping type, and an upper portion 4 of a second doping type proximate to the silicon layer surface of the gate 1. The upper portion 4 extends from the edge to the gate 1 so that it covers the lower portion 3 only partially, and contact 6 is made to both portions. The upper and lower layers are in this example preferably made through ion implantation.

FIG. 1 bis illustrates another embodiment of the invention in which epitaxial growth can be used for the source and the drain 5 as proposed in prior art. In particular, US 6,946,371, Sept 20, 2005 Langdo, et al. "Methods of fabricating semiconductor structures having epitaxially grown source and drain elements" can be used or other relevant methods disclosed in the art. In this embodiment, the region 3 covers entirely the region 4 as a superimposed layer. The upper and lower portions, created through epitaxial growth, and are then etched to make contact to both portions. The connector 6 has therefore a different shape as in Figure 1.

Persons of ordinary skill in the art will readily appreciate though that the specific geometry and nano-scale dimensions employed for the device of present invention could yet be of the structural arrangements or dimensions appropriate for an application. The processing involved in making appropriate gate structures, source and drain contacts, spacers and other manufacturing steps which are already in use in semiconductor industry are not illustrated to make the particular points of novelty of present invention clear. It would for example also be possible to consider a MOSFET device, in which the source region would comprise two alternative portions of opposite doping type wherein these portions would be created side by side along the width of the source and contact made to all of them.

The feature which is different from regular MOSFETs for all possible embodiments is the particular doping of the source. Another feature of the MOSFET according to the invention is to have an intrinsic bulk semiconductor in which p and n channel MOSFETs are fabricated on the same intrinsic bulk material without n and p well regions.

The PISCES-IIb semiconductor drift-diffusion simulator has been used to obtain the characteristics of the disclosed invention. The potential and current voltage characteristics of our invention have been obtained with the dimensions indicated on FIG. 1, that is the drain 5 and source 3 size (85nm), gate 1 length (75nm), drain 5 and source 3/4 thickness (50nm), wherein the source region 4 is of 40 nm width and 25nm thickness, body region 8 thickness (250 micrometer). The overall device width is 245nm. These results are provided on most of the remaining figures.

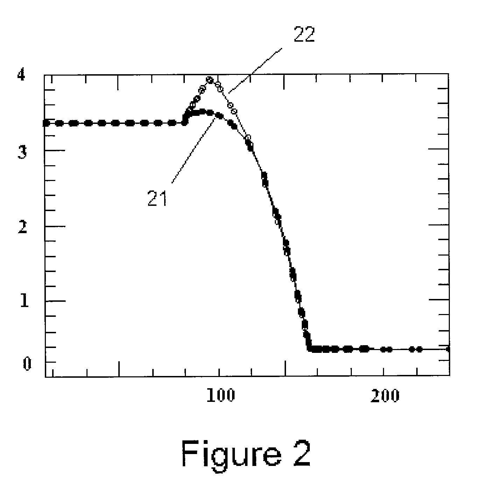

FIG. 2 compares the potential barrier from the source to the drain for our invention (arrow 22) and a regular MOSFET (arrow 21) of the same gate length and a bulk with a doping density of 10¹⁷/cm3. This MOSFET does not have halo doping and it suffers from short channels effects; the figure is provided to demonstrate the ability of the disclosed invention to reduce short channel effects. The gate length is indicated in nanometers on the X axis and the potential is indicated in volts on the Y axis. As it can be observed, the potential barrier for present invention has not been lowered by the drain voltage, while the regular MOSFET shows the barrier lowering as a result of the drain voltage. This is a clear indication that the problem of has been reduced by this invention.

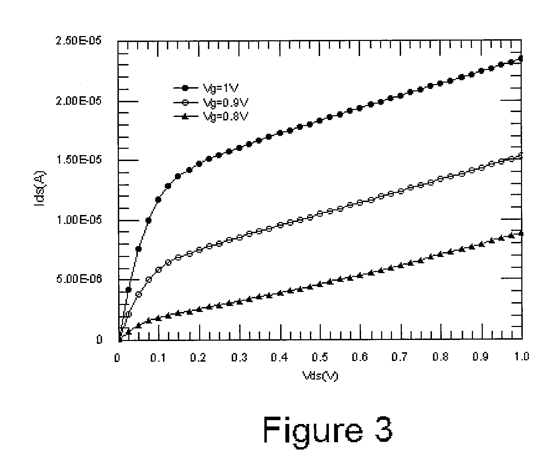

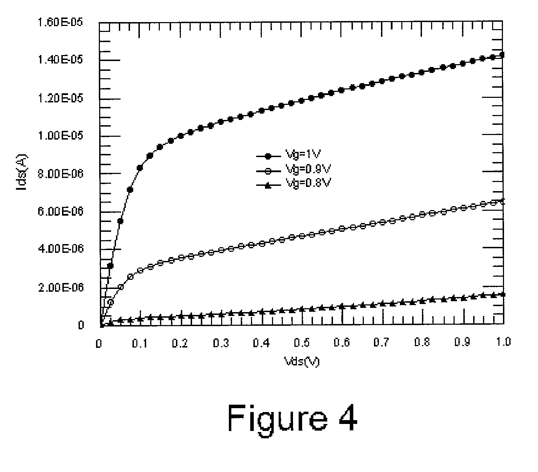

The simulated current-voltage relation of the present invention is compared to a regular MOSFET in figures 3 to 6. FIG.3 and FIG.4 show the current I_{ds} between the drain and the source as a function of the voltage V_{ds} between the drain and the source, for different gate voltages Vg, for a regular MOSFET and the MOSFET according to the invention respectively. Comparing Fig3 with Fig4, it can be observed that the magnitude of the ON current for the regular MOSFET and the subject of this invention are comparable. However, it can be appreciated that the less steep slope of the current-voltage relation, as well as the current magnitude with respect to the gate voltage, indicate that the short channel effects are much less severe for the subject of this invention, which has an intrinsic bulk.

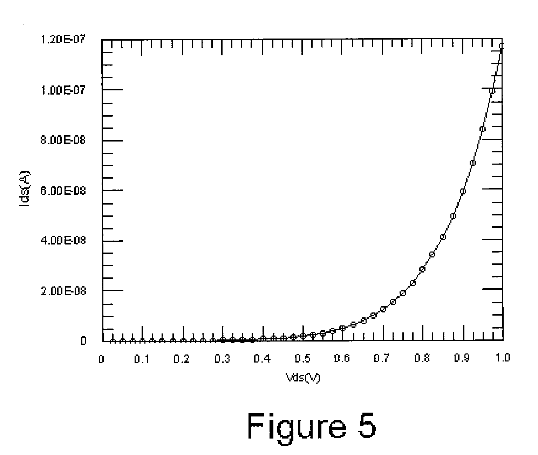

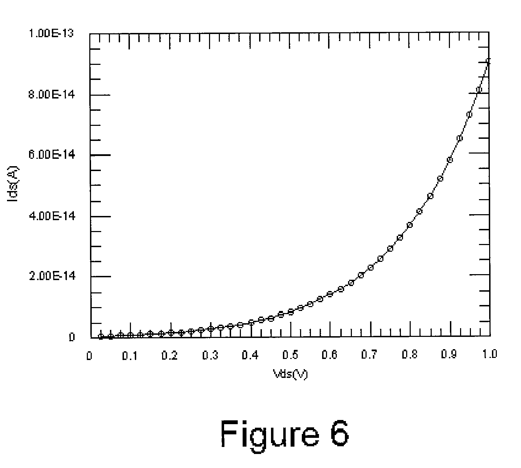

FIG. 5 and FIG.6 compare the OFF currents I_{ds} of a regular MOSFET and the proposed MOSFET according to this invention, i.e. when the gate voltage Vg is equal to zero, as a function of the drain-source voltage V_{ds}. The OFF current of the present invention is orders of magnitude less than the one for a regular MOSFET. The device according to the invention is intrinsic and has much less OFF current than a MOSFET doped by 10 ¹⁷/ cm3 impurities. Theses figures clearly demonstrate that the disclosed intrinsic device does turn off at gate voltage zero. In contrast, it goes without saying that an intrinsic regular MOSFET does not and cannot turn off. By switching the impurity types of the source and drain, a p-type device is obtained and its OFF current is exactly what is shown on Fig.6. P and n-channel devices can thus be obtained using an intrinsic bulk with a very small turn off current, whereby the drastically reduced leakage current in OFF state materializes the suppression of short effect channels.

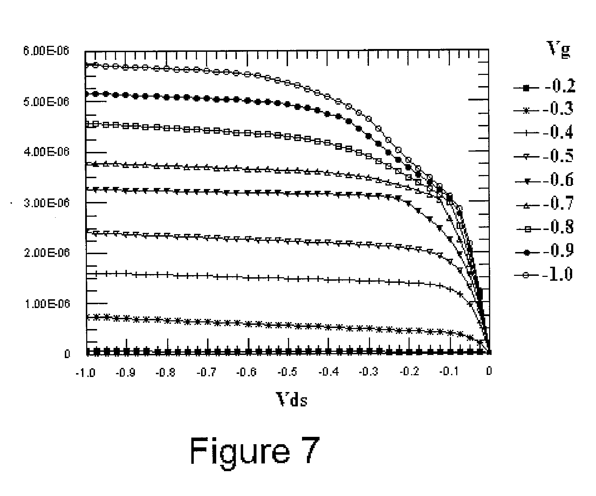

FIG. 6 and FIG. 7 illustrate the intensity-voltage (I-V) relation for a p channel device according to the disclosed invention. The device is similar to the n channel device with an intrinsic bulk, but the source and drain doping impurities are reversed. In this case, region 3 is n-doped with 10 ¹⁸/ cm3 impurity concentration and regions 4 and 5 are p-doped with 10 ¹⁹/ cm3 impurity concentration. As is observed in these figures, there are well defined ON and OFF states. A regular MOSFET would not turn off, if its bulk was intrinsic.

The physical reason causing such improvements in the characteristics is that the extra doped region in the source, which is short circuited to the oppositely doped source region, forces a certain built-in voltage to be dropped between itself and the edge of the channel which is in contact with the top portion of the source, and this creates a potential barrier for the carriers coming from the source toward the drain. When the gate voltage is zero, this barrier still exists and is even more pronounced and the device exhibits negligible leakage current. When gate voltage is applied the potential barrier decreases and allows the carriers to flow.

Also, when the drain voltage is increased, the potential barrier at the source is not affected by much and the problem of DIBL does not occur. The same reason applies to the punch through problem.

The physics behind the operation of this MOSFET is different from conventional MOSFETs but the overall current-voltage relation is similar and appropriate for circuit applications.

## Claims

1. A MOSFET with an intrinsic bulk comprising an extra dopant region (3) inside the source of a doping type opposite to that of the source.

2. The device of claim 1, wherein said extra dopant region (3) is a highly doped bottom region of said source.

3. The device of claim 1, in which said source comprises a lower portion of a first doping type (3), and an upper portion (4) of a second doping type proximate to the silicon layer surface of the gate (1), wherein said upper portion (4) extends from the edge of said gate (1) such that it covers said lower portion only partially; wherein contact (6) is made to both said portions (3,4).

4. The device of claim 3, acting as a MOSFET transistor, wherein leakage current is greatly reduced in off state.

5. The device of claim 1, in which said source comprises: a lower portion of a first doping type (3); and an upper portion of a second doping type proximate to the silicon layer surface of the gate (1), wherein said upper portion (4) extends from the edge of said gate so that it covers said lower portion (3) completely.

6. The device of claim 1, in which said source comprises two alternative portions of opposite doping type, wherein said portions are created side by side along the width of said source and contact is made to both said portions.

7. The device of any of the previous claims, having an intrinsic bulk semiconductor and wherein p and n channel MOSFETs are fabricated on the same intrinsic bulk material without n and p well regions.
